# NEUE EUROPÄISCHE PATENTSCHRIFT

(11) **EP 0 756 782 B2**
(45) Veröffentlichungstag und Bekanntmachung des Hinweises auf die Entscheidung über den Einspruch: **14.01.2004**
(45) Hinweis auf die Patenterteilung: 17.12.1997
(21) Anmeldenummer: 95915871.8
(22) Anmeldetag: 12.04.1995
(51) Int. Cl.: H03K 17/16

(54) **GLEICHSTROM-STEUERSCHALTUNG**
DC CONTROL CIRCUIT
CIRCUIT DE COMMANDE A COURANT CONTINU

(30) Priorität: 19.04.1994 DE 4413546
(43) Veröffentlichungstag der Anmeldung: 05.02.1997
(73) Patentinhaber: Michael Riedel Transformatorenbau Elektronik GmbH, 74532 Ilshofen (DE)
(72) Erfinder: Marks, Walter, 74653 Künzelsau (DE)
(74) Vertreter: Otten, Hajo, Dr.-Ing.
(86) Internationale Anmeldenummer: PCT/EP1995/001371
(87) Internationale Veröffentlichungsnummer: WO 1995/028767

(56) Entgegenhaltungen:
- EP-A- 0 493 185
- EP-A- 0 508 171
- EP-A- 0 554 154
- GB-A- 2 257 855
- US-A- 4 746 813

## Beschreibung

Die Erfindung betrifft eine Gleichstrom-Steuerschaltung zum Ein- und Ausschalten des Stromflusses in einem induktivitätsbehafteten Laststromkreis durch Ansteuern eines Halbleiterschalters nach der Gattung der Ansprüche 1 und 4.

Zum Ein- und Ausschalten von Gleichstrom ist üblicherweise eine Reihenschaltung von Spannungsquelle, Halbleiterschalter und Verbraucher bzw. Last vorhanden. Bei induktivitätsbehafteten Verbrauchern wird eine Freilaufdiode parallel zum induktivitätsbehafteten Teil des Stromkreises geschaltet, wobei die Induktivität auch beispielsweise durch die Leitungen des Stromkreises verursacht oder mitverursacht sein kann.

Ein beispielsweise als MOSFET ausgebildeter Halbleiterschalter wird mit Hilfe der GATE-SOURCE-Spannung gesteuert. Solange ein solcher Transistor leitet, liegt am Verbindungspunkt zwischen dem Transistor und dem Verbraucher - und demgemäß auch an der Freilaufdiode - im wesentlichen das Versorgungspotential. Wird nun die GATE-SOURCE-Spannung zum Sperren des Transistors emiedrigt, wird der Innenwiderstand des Transistors immer höher und die in ihm in Wärme umgewandelte Leistung immer größer, da der Strom auf Grund der Wirkung der Induktivität im Laststromkreis nur wenig abnimmt. Es ist daher erforderlich, daß die Freilaufdiode den Stromfluß übernimmt, bevor im Transistor so viel Wärme entwickelt wird, daß dieser zerstört wird.

Aus der DE 4013 997 Al ist es hierzu bekannt, einen Ausschalt-Steuerstrom für das GATE des Transistors so lange auf einem hohen Wert zu halten, bis eine Auswerteeinrichtung angibt, daß die Freilaufdiode in Schaltpunktnähe ist. Nun wird der Steuerstrom auf einen niedrigeren Wert umgeschaltet. Durch diese Maßnahme werden zwar die unerwünschten Auswirkungen beim Umschalten weitgehend vermieden, nämlich die Erzeugung einer Verlustleistung im Transistor und die Erzeugung von Störspannungen und Störimpulsen, jedoch wird die maximale Schaltgeschwindigkeit dadurch begrenzt, daß bei Erhöhung der DRAIN-SOURCE-Spannung und der dabei gleichzeitigen Verringerung der wirksamen GATE-SOURCE-Kapatzität eines MOSFET der Ausschaltvorgang beschleunigt wird und deshalb der maximale Ausschaltstrom nur so groß gewählt werden darf, daß ein rechtzeitiges Umschalten auf den kleinen Ausschaltstrom in Schaltpunktnähe der Diode noch möglich ist.

Beim Einschalten des Stromes tritt ein anderes Problem auf, nämlich das der Gefahr eines Kurzschlusses. Erfolgte erst kurz vor einem Wiedereinschalten ein Ausschalten, fließt noch Strom im Laststromkreis, und zwar über die Freilaufdiode. Sinkt der Widerstand des Transistors mit zunehmender GATE-SOURCE-Spannung zum Einschalten des Transistors, so wird das Potential am Verbindungspunkt zwischen Transistor und Freilaufdiode positiv, so daß die Diode sperrt. Jedoch erfolgt auch dieses Sperren nicht schlagartig, so daß die Gefahr besteht, daß bei Erhöhung der GATE-SOURCE-Spannung des Transistors dieser bereits voll leitet, wenn die Diode noch nicht gesperrt hat. Dies hätte offensichtlich einen Kurzschluß zur Folge, mit der Gefahr einer Zerstörung des Transistors und/oder der Diode.

Um dies zu verhindern, wurde bereits in der vorstehend genannten DE 40 13 997 Al vorgeschlagen, den Steuerstrom zunächst auf einem niedrigen Niveau zu halten oder - bei Verwendung von bipolaren Transistoren - nur langsam ansteigen zu lassen, bis die Auswerteeinrichtung das Schalten der Freilaufdiode erkannt hat. Erst dann wird der Steuerstrom auf einen wesentlich höheren Wert umgeschaltet. Ein Kurzschluß wird dadurch zwar wirksam verhindert, jedoch wird bei dem dort vorgesehenen konstanten Einschaltstrom die GATE-SOURCE-Spannung des Transistors kontinuierlich erhöht. Überschreitet diese die Einsatzspannung des Transistors, so fließt zunehmend Strom durch diesen. Hierdurch verringert sich der Strom durch die Diode, und durch weiter steigenden DRAIN-SOURCE-Strom verringert sich der Strom durch die Diode so weit, bis diese stromlos wird. Da durch den Transistor Strom fließt und gleichzeitig die volle Versorgungsspannung an ihm abfällt, entsteht in diesem Abschnitt des Einschaltvorgangs eine hohe Verlustleistung, die der Transistor in Wärme umsetzen muß.

Eine Aufgabe der vorliegenden Erfindung besteht daher darin, die bekannte Gleichstrom-Steuerschaltung so weiterzubilden, daß beim Ein- und/oder Ausschalten des Stroms eine geringere Verlustleistung bei gleichzeitig schnelleren Schaltvorgängen entsteht, wobei Störspannungen und Störimpulse weitestehend vermieden werden sollen.

Diese Aufgabe wird erfindungsgemäß dadurch gelöst, daß eine in Abhängigkeit von der Spannung am Freilauf-Halbleiterbauelement steuerbare Ein- bzw. Ausschaltstromquelle zur konntinuierlichen Verringerung des Betrags des Ein- bzw. Ausschaltsteuerstroms bis zu einem Minimalwert vorgesehen ist, wobei der Minimalwert im wesentlichen bei einem Spannungswert vor 0 Volt der sich verringernden Spannung am Freilauf-Halbleiterbauteil erreicht wird.

Da bei der erfindungsgemäßen Gleichstrom-Steuerschaltung beim Ausschalten des Gleichstromes der Ausschaltstrom nicht in einem Schritt, sondern in Abhängigkeit zur Verringerung der Sperrspannung des Freilauf-Halbleiterbauteils, das beim Ausschalten des Halbleiterschalters einschalten muß, kontinuierlich verkleinert wird, hat der Ausschaltstrom in Schaltpunktnähe des Freilauf-Halbleiterbauteils einen Wert erreicht, der ein Schalten bei minimaler Verlustleistung und Störleistung gewährleistet. Der Ausschaltstrom kann im Vergleich zu der bekannten Steuerschaltung wesentlich größer gewählt werden, weil zunächst nur die GATE-SOURCE-Spannung verkleinert wird, aber noch keine wesentliche Veränderung der DRAIN-SOURCE-Spannung eintritt. lst der DRAIN-SOURCE-Widerstand des Transistors jedoch so groß, daß die DRAIN-SOURCE-Spannung auf Grund des vom Transistor geführten Stroms steigt und somit die Sperrspannung des Freilauf-Halbleiterbauteils kleiner wird, so wird damit der Ausschaltstrom proportional zur Sperrspannung der Diode so verringert, daß die Diode in Schaltpunktnähe genügend Zeit für ihren Einschaltvorgang hat. Hierdurch wird insgesamt eine schnellere Schaltgeschwindigkeit erreicht.

Analog zum Ausschalten wird erfindungsgemäß auch beim Einschalten ein zunächst hoher Einschaltstrom in Abhängigkeit von der Spannung am Freilauf-Halbleiterbauteil kontinuierlich so weit verringert, daß dieser in Schaltpunktnähe des Freilauf-Halbleiterbauteils den notwendigen kleinen Minimalwert des Steuerstroms erreicht hat. So wird dem Freilauf-Halbleiterbauteil die notwendige Schaltzeit zur Verfügung gestellt, um die sonst unvermeidliche Entstehung von Störleistung zu verhindern. Da das Freilauf-Halbleiterbauteil sehr schnell in Schaltpunktnähe gebracht wird, wird die Zeit, in der eine hohe Verlustleistung im Transistor entsteht, bevor das Freilauf-Halbleiterbauteil in Schaltpunktnähe ist, erheblich verkürzt. Hierdurch verringert sich neben der Schaltzeit auch die Verlustleistung, bei geringer Störleistung.

Durch die in den Unteransprüchen aufgeführten Maßnahmen sind vorteilhafte Weiterbildungen und Verbesserungen der in den Ansprüchen 1 und 4 angegebenen Gleichstrom-Steuerschaltung möglich.

Die Einschaltstromquelle und die Ausschaltstromquelle weisen in vorteilhafter Weise Begrenzungseinrichtungen auf, um den sich verringernden Ein- bzw. Ausschaltsteuerstrom auf den eingestellten Minimalwert zu begrenzen. Die Verringerung des Ein- bzw. Ausschaltsteuerstroms bis zum Minimalwert erfolgt dabei vorzugsweise proportional zur Veränderung der gegen Null gehenden Spannung am Freilauf-Halbleiterbauteil. Der Minimalwert des Stroms wird dabei so gewählt, daß das Freilauf-Halbleiterbauteil die notwendige Umschaltzeit zur Verfügung hat.

Zur Verringerung der Schaltzeiten tragen insbesondere auch Mittel zur Umschaltung der Ein- und/oder Ausschaltstromquelle auf einen wesentlich höheren Betrag des Steuerstroms nach erfolgter Umschaltung des Freilauf-Halbleiterbauteils bei. Die Ein- und/oder Ausschaltstromquelle besitzt hierbei in einer zweckmäßigen Ausgestaltung wenigstens zwei Teilstromquellen, die alternativ durch positive oder negative Spannungen am Freilauf-Halbleiterbauteil einschaltbar sind. Hierzu können zweckmäßigerweise invers gepolte Dioden entsprechend den Steuereingängen der Stromquellen vorgeschaltet sein.

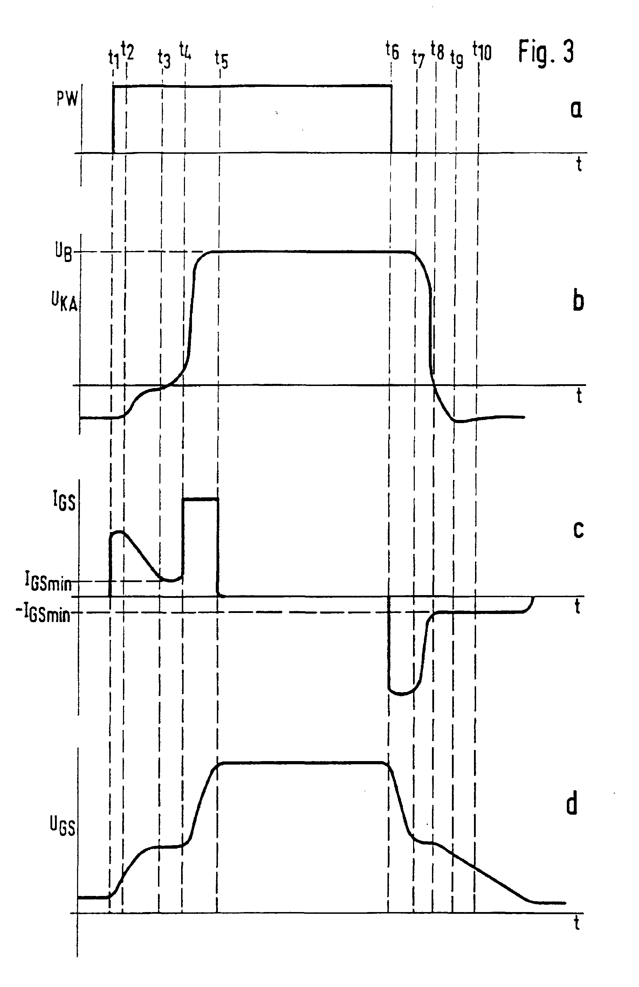

Die kürzestmögliche Einschaltzeit wird durch die unvermeidliche Ausschältverzögerungszeit (Fig.3 (b), Zeitspanne t6 bis t8) vorgegeben. Eine weitere Verkleinerung der ausgangsseitigen Verbraucherspannung über die Verkürzung der Einschaltzeit ist daher nicht mehr möglich. Sollen dennoch kleinere Ausgangsspannungen erreicht werden, als es die kürzestmögliche Einschaltzeit erlauben würde, so kann dies in vorteilhafter Weise durch Mittel erfolgen, die bei einer Unterschreitung der ausgangsseitigen Verbraucherspannung unter einen vorgebbaren Bruchteil der Versorgungsspannung einen den Halbleiterschalter nicht mehr vollständig einschaltenden Einschaltsteuerstrom vorgeben. Die Differenz der Spannung fällt dann bei nicht mehr voll eingeschaltetem Transistor über diesem ab. Die Ausgangsspannung kann hierdurch sehr kleine Werte annehmen, so daß ein Regler, der die Pulsweite ausgibt, Ausgangsspannungen einstellen kann, die kleiner sind, als sie über die kürzestmögliche Einschaltzeit realisierbar wären.

Eine zweckmäßige Realisierung kann dadurch erfolgen, daß eine Vergleichseinrichtung zum Vergleich der Versorgungsspannung mit der am wenigstens einem der Verbraucher abfallenden Spannung vorgesehen ist, wobei durch diese Vergleichseinrichtung der Betrag des Steuerstroms nach erfolgter Umschaltung des Freilauf-Halbleiterbauteils in Abhängigkeit des Verhältnisses dieser Spannungen eingestellt wird.

Dem Steuereingang des Halbleiterschalters ist zweckmäßigerweise ein durch ein Steuersignal für seinen jeweiligen Schaltvorgang steuerbarer Umschalter vorgeschaltet zur Umschaltung zwischen der Ein- und der Ausschaltstromquelle. Dabei kann das Steuersignal zweckmäßigerweise ein pulsweitenmoduliertes Signal sein. Es ist jedoch auch möglich, mit dem Steuersignal direkt die Ein- und die Ausschaltstromquelle alternativ anzusteuern.

Zwei Ausführungsbeispiele der Erfindung sind in der Zeichnung dargestellt und in der nachfolgenden Beschreibung näher erläutert. Es zeigen:
- Fig. 1: eine schaltungsmäßige Ausgestaltung eines ersten Ausführungsbeispiels,
- Fig. 2: eine schaltungsmäßige Ausgestaltung eines zweiten Ausführungsbeispiels, erweitert gegenüber dem ersten Ausführungsbeispiel um eine Vergleichseinrichtung zur weiteren Verringerung der Verbraucherspannung, und
- Fig. 3: ein Signaldiagramm zur Erläuterung der Wirkungsweise.

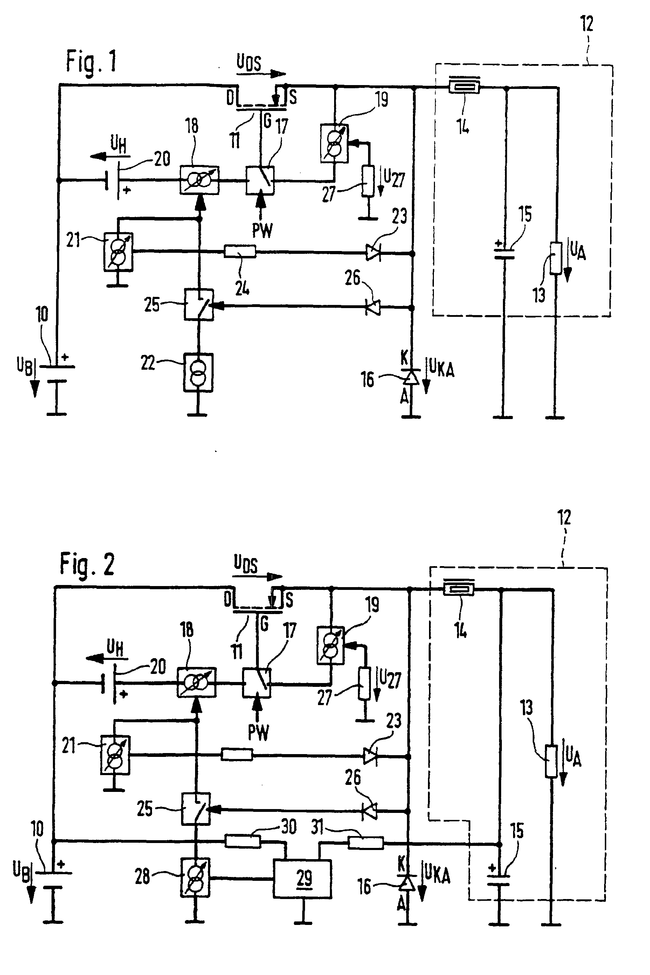

Bei dem in Fig. 1 dargestellten ersten Ausführungsbeispiel bilden eine Versorgungsspannungsquelle 10 mit der Versorgungsspannung U_{B}, die DRAIN-SOURCE-Strecke eines als MOSFET ausgebildeten Transistors 11 und eine Verbraucheranordnung 12 einen Stromkreis. In Reihe zu einem Verbraucher 13 ist dabei eine Induktivität 14 geschaltet, wobei eine Kapazität 15 parallel zum Verbraucher 13 geschaltet ist. Diese Anordnung soll einen beliebigen Verbraucher mit Ohmschen, kapazitiven und induktiven Anteilen darstellen. Bei der Induktivität 14 kann es sich beispielsweise um eine Induktivitätswicklung handeln, jedoch kann eine solche Induktivität auch allein durch die Induktivität der Leitungen des Stromkreises oder durch Lastwiderstände mit induktivem Anteil verursacht sein. Am Verbraucher fällt eine Verbraucherspannung U_{A} ab, während an der DRAIN-SOURCE-Strecke des Transistors 11 die DRAIN-SOURCE-Spannung U_{DS} abfällt.

Parallel zur Verbraucheranordnung 12 ist eine Freilaufdiode 16 geschaltet. Auch jedes beliebige andere Freilauf-Halbleiterbauteil kann hierzu verwendet werden, z. B. ein unipolarer Transistor oder eine Gleichrichterdiode im magnetisch (transformatorisch) gekoppelten Lastkreis bzw. Verbraucherkreis. Das GATE G des Transistors 11 wird über eine Umschalteinrichtung 17 mittels einer pulsweiten-modulierten Signalfolge PW so angesteuert, daß das GATE G zum Einschalten des Transistors 11 mit einer Einschaltstromquelle 18 und zum Ausschalten des Transistors 11 mit einer Ausschaltstromquelle 19 verbunden ist, die versorgungsmäßig mit dem SOURCE-Anschluß S des Transistors 11 verbunden ist. Zur Spannungsversorgung der Einschaltstromquelle 18 dient die Reihenschaltung der Versorgungsspannungsquelle 10 mit einer Hilfsspannungsquelle 20, deren Hilfsspannung U_{H} zur Versorgungsspannung U_{B} addiert wird. Beispielsweise bei einem N-Kanal-MOSFET, der als SOURCE-Folger geschaltet ist, muß die GATE-Spannung zum Einschalten positiver werden als die Versorgungsspannung am DRAIN-Anschluß. Aus diesem Grunde wird die Hilfsspannungsquelle 20 im vorliegenden Falle benötigt, da deren positiver Anschluß somit auf dem Potential U_{B} + U_{H} liegt.

An die Einschaltstromquelle 18 sind zwei weitere Hilfsstromquellen 21, 22 angeschlossen. Die Hilfsstromquelle 21 ist als steuerbare Stromquelle ausgebildet und wird durch die an der Freilaufdiode 16 abfallende Spannung U_{KA} über eine Diode 23 und einen dazu in Reihe geschalteten Widerstand 24 gesteuert. Die zweite Hilfsstromquelle 22 ist eine ungesteuerte Stromquelle, die über einen steuerbaren Schalter 25 mit der Einschaltstromquelle 18 verbunden ist. Der steuerbare Schalter 25 wird ebenfalls durch die Spannung U_{KA} über eine zur Diode 23 invers gepolte Diode 26 gesteuert. Die beiden Dioden 23, 26 sind so gepolt, daß bei leitender Freilaufdiode 16 und negativer Flußspannung - U_{KA} der steuerbare Schalter 25 gesperrt und die Hilfsstromquelle 21 auf einen bestimmten Stromwert eingestellt wird. Im anderen Falle, also bei positiver Spannung an der Kathode der Freilaufdiode 16, wird der steuerbare Schalter 25 geschlossen und die Hilfsstromquelle 21 gesperrt. Die von den Hilfsstromquellen 21, 22 der Einschaltstromquelle 18 zugeführten Ströme dienen entweder als Steuerströme zur Steuerung des Ausgangsstroms dieser Einschaltstromquelle 18, oder sie werden zu einem von der Einschaltstromquelle 18 erzeugten Minimalstrom I_{GSmin} addiert.

Die Ausschaltstromquelle 19 ist ebenfalls als steuerbare Stromquelle ausgebildet und wird über eine an einem Widerstand 27 abfallende Spannung U₂₇ gesteuert. Die Spannung U₂₇ entspricht der Spannung U_{KA}. Hierzu ist der Widerstand 27 beispielsweise so mit der Ausschaltstromquelle 19 verbunden, daß er praktisch parallel zur Freilaufdiode 16 liegt.

Die Wirkungsweise des in Fig. 1 dargestellten Ausführungsbeispiels wird nun im folgenden anhand des in Fig. 3 dargestellten Signaldiagramms erläutert. Zunächst wird das Einschalten des Transistors 11 erläutert, das in der Zeitspanne t1 bis t5 erfolgt. Wechselt zum Zeitpunkt t1 die pulsweitenmodulierte Signalfolge PW von logisch 0 nach logisch 1, so wird das GATE G über die Umschalteinrichtung 17 mit der Einschaftstromquelle 18 verbunden und somit der Einschaltvorgang eingeleitet. Zu diesem Zeitpunkt ist die Freilaufdiode 16 stromleitend und hat eine hohe negative Flußspannung - U_{KA}. Die Diode 26 ist dadurch gesperrt und die Diode 23 stromleitend. Es fließt ein Strom durch den Widerstand 24 in Abhängigkeit der an der Freilaufdiode 16 abfallenden Flußspannung, wobei dieser Strom die Steuergröße für den Ausgangsstrom der Hilfsstromquelle 21 bildet. Der proportionale Zusammenhang zwischen dem Steuerstrom und der Flußspannung ist durch den Widerstand 24 gegeben. Der Einschaltstrom I_{GS'} der von der Einschaltstromquelle 18 zum GATE des Transistors 11 fließt, ist zum Zeitpunkt t1 durch den hohen Steuerstrom der Hilfsstromquelle 21 auf einen hohen Wert eingestellt, da die Flußspannung - U_{KA} zu diesem Zeitpunkt einen hohen negativen Wert hat. Auf Grund des hohen Einschaltstroms I_{GS} steigt die Spannung U_{GS}, also die GATE-SOURCE-Spannung, des Transistors 11 schnell an (siehe Fig. 3 (d)). Überschreitet die Spannung U_{GS} die Einsatzspannung des Transistors 11, fließt dort zunehmend Strom, wodurch sich der Strom durch die Freilaufdiode 16 entsprechend verringert. Die Flußspannung - U_{KA} wird dadurch kleiner. Entsprechend der Verringerung der Flußspannung - U_{KA} der Freilaufdiode 16 verringert sich auch der Steuerstrom für die Hilfsspannungsquelle 21 während der Zeitspanne t2 bis t3. Zum Zeitpunkt t3 hat sich die Flußspannung - U_{KA} so weit verringert, daß die Freilaufdiode 16 in Schaltpunktnähe ist. Die Steuergröße für die Hiffsstromquelle 21 verringert sich dadurch praktisch auf den Wert Null, und durch die Einschaltstromquelle 18 fließt nur noch der fest eingestellte Minimal strom I_{GSmin}, dessen Größe so gewählt ist, daß der Freilaufdiode 16 die notwendige Umschaltzeit zur Verfügung steht (t3 bis t4).

Zum Zeitpunkt t4 ist der kritische Bereich des Umschaltvorgangs der Freilaufdiode 16 beendet, und sie hat eine positive Sperrspannung U_{KA} angenommen. Die Diode 23 ist jetzt gesperrt und die Diode 26 stromleitend und schaltet über den Schalter 25 die zweite Hilfsstromquelle 22 ein, welche den Einschaltstrom I_{GS} auf einen hohen Wert einstellt, wodurch der jetzt unkritische Einschaltvorgang des Transistors 11 bis zum Zeitpunkt t5 schnell abgeschlossen wird.

Während der Zeitspanne t2 bis t4 muß im Transistor 11 auf Grund des durch ihn fließenden Stroms und der hohen Spannung U_{DS} = U_{B} + U_{AK} eine hohe Verlustleistung umgesetzt werden. Wie die Beschreibung in Verbindung mit dem Signaldiagramm gemäß Fig. 3 zeigt, wird diese Zeitspanne durch die beschriebenen Maßnahmer erheblich verkleinert (im Vergleich zum Stand der Technik), ohne daß eine zusätzliche Störleistung entsteht.

Zum Zeitpunkt t6 wird der Ausschaltvorgang des Transistors 11 dadurch eingeleitet, daß das Signal der pulsweiten-modulierten Signatfolge PW von logisch 1 nach logisch 0 wechselt. Dadurch wird das GATE des Transistors 11 über die Umschalteinrichtung 17 mit der Ausschaltstromquelle 19 verbunden. Die Spannung U_{DS} am Transistor 11 ist im eingeschalteten Zustand dieses Transistors sehr klein, so daß die Spannung U_{KA} = U₂₇ im wesentlichen mit der Versorungsspannung U_{B} übereinstimmt, das heißt sehr hoch ist. Die Ausschaltstromquelle 19 ist dadurch auf einen hohen Ausschaltstrom - I_{GS} eingestellt. Dieser Strom verkleinert die Spannung U_{GS}, wodurch der Widerstand des Transistors während der Zeitspanne t6 bis t7 ansteigt. Zum Zeitpunkt t7 hat der Widerstand der DRAIN-SOURCE-Strecke des Transistors 11 einen Wert erreicht, der bei weiterer Verringerung von U_{GS} zu einem entsprechenden Anstieg der Spannung U_{DS} führt. In gleichem Maße verringert sich dadurch die Spannung U_{KA} an der Freilaufdiode 16 und damit auch die Spannung U₂₇, so daß der Ausschaltstrom - I_{GS} proportional zur Verringerung der Spannung U_{KA} sinkt und zum Zeitpunkt t8 den in der Ausschaltstromquelle 19 festgelegten Minimalstrom - I_{GSmin} erreicht, der betragsmäßig im wesentlichen dem Minimalstrom der Einschaltstromquelle 18 entspricht. Die Spannung U_{KA} = U₂₇ ist zu diesem Zeitpunkt im wesentlichen Null, t9 bis t10 ist die Zeitspanne, welche die Freilaufdiode 16 benötigt, um den durch die Induktivität 14 bewirkten Strom vollständig zu übernehmen. Zum Zeitpunkt t10 ist der Ausschaltvorgang abgeschlossen.

Die problematischen unvermeidbaren und unerwünschten Schaltzeiten der Freilaufdiode sind einerseits bedingt durch die Diode selbst und andererseits durch unerwünschte induktive Effekte in den Anschlußleitungen sowie durch Kondensatoren, und versachen hochfrequente Oszillationen, hohe Stromsteilheiten und Spannungsspitzen (Störspannungen). Die Schaltzeiten werden durch die beschriebene Anordnung so eingestellt, daß die unerwünschten Effekte praktisch nicht mehr entstehen und die elektromagnetische Verträglichkeit sichergestellt ist.

Das in Fig. 2 dargestellte zweite Ausführungsbeispiel entspricht weitgehend dem ersten Ausführungsbeispiel. Gleiche oder gleich wirkende Bauteile und Baugruppen sind daher mit denselben Bezugszeichen versehen und nicht nochmals beschrieben. Im Unterschied zum ersten Ausführungsbeispiel wird die Hilfsstromquelle 22 durch eine gesteuerte Hilfsstromquelle 28 ersetzt, die von einer Vergleichseinrichtung 29 gesteuert wird. Die ausgangsseitige Steuergröße der Vergleichseinrichtung 29 beruht auf dem Vergleich der Spannungen U_{B} und U_{A} am Verbraucher 13 bzw. der Verbraucheranordnung 12. Diese beiden Spannungen U_{B} und U_{A} werden der Vergleichseinrichtung 29 über zwei Widerstände 30, 31 zugeführt. Der Strom der Hilfsstromquelle 28 wird dann auf kleinere Werte gesteuert, wenn ein bestimmtes Verhältnis U_{A}/U_{B} unterschritten wird, welches durch das Widerstandsverhältnis R/n·R festgelegt ist. Dabei hat der Widerstand 31 den Wert R und der Widerstand 30 den Widerstandwert n · R. Bei einer Pulsweite von 5 % ist beispielsweise n = 20.

Die kürzestmögliche Einschaltzeit des Transistors 11 bei sehr geringem Pulsweitenverhältnis wird durch die unvermeidliche Ausschaltverzögerungszeit (Fig. 3 (b), Zeitspanne t6 bis t8) vorgegeben. Eine weitere Verkleinerung der Spannung U_{A} ist durch weitere Verkürzung der Einschaltzeit daher nicht mehr möglich. Sollen dennoch kleinere ausgangsseitige Verbraucherspannungen U_{A} erreicht werden, als dies die kürzestmögliche Einschaltzeit erlauben würde, kann dies nur über ein Spannungsabsenkung am SOURCE-Anschluß des Transistors 11 während der Einschaltzeit dieses Transistors erreicht werden, also während der Zeitspanne t4 bis t5. Die Differenz der Spannung muß dann über den Transistor 11 abfallen, der zu diesem Zweck jetzt nicht mehr vollständig eingeschaltet wird. Dies wird durch die Anordnung 28 - 31 erreicht.

Bei größeren Einschaltzeiten hat die Hilfsstromquelle 28 die gleiche Funktion wie die Hilfspannungsquelle 22 gemäß Fig.1. Wenn das Verhältnis der Spannungen U_{A}/U_{B} jedoch kleiner ist als das Widerstandsverhältnis R/n·R, so steuert im Zeitpunkt t4 die Vergleichseinrichtung 29 die Hilfsstromquelle 28 auf kleinere Stromwerte. Dadurch verkleinert sich der Einschaltstrom I_{GS}, und die Zeit für das vollständige Einschalten des Transistors 11 wird entsprechend verlängert. Eine weitere Verringerung der ausgangsseitigen Verbraucherspannung U_{A} hat zur Folge, daß die Vergleichseinrichtung 29 den Strom der Hilfsstromquelle 28 bis auf den Wert Null zurücknehmen kann, wodurch sich der Einschaltstrom I_{GS} so weit verringert, bis er den Wert I_{GSmin} erreicht hat. Der Transistor erreicht dadurch bei einer kleinen Einschaltzeit, die nahe der kleinstmöglichen Einschaltzeit ist, nur kleine Leitwerte, so daß während dieser Einschaltzeit eine Spannung über ihm abfällt, um die sich die Spannung an seinem SOURCE-Anschluß verringert. Die Ausgangsspannung U_{A} kann dadurch sehr kleine Werte annehmen, so daß ein Regler, der die Pulsweite ausgibt, Ausgangsspannungen einstellen kann, die kleiner sind, als sie über die kürzestmögliche Einschaltzeit eigentlich realisierbar wären.

Die erfindungsgemäßen Maßnahmen sind sowohl bei Schaltnetzteilen mit einem High-Side-Schalter oder einem Low-Side-Schalter als auch bei magnetisch gekoppelten Schaltnetzteilen anwendbar. Der Transistor 11 kann ein MOSFET (N-Kanal oder P-Kanal) oder ein IGBT-Transistor sein.

In Abwandlung des beschriebenen Ausführungsbeispiels kann der höchstmögliche Ausschaltstrom - I_{GS} auch begrenzt sein. Erst nach Unterschreitung einer diesem Grenzwert entsprechenden Spannung U₂₇ am Widerstand 27 wird dann der Ausschaltstrom kontinuierlich verringert, beispielsweise proportional verringert.

Um den Einschaltvorgang schneller zu machen, wird der Einschaltstrom nach dem Umschaltvorgang der Freilaufdiode 16 während des Zeitintervalls t4 bis t5 stark erhöht, wie dies im Zusammenhang mit Fig. 1 beschrieben worden ist. Entsprechend kann auch beim Ausschalten des Transistors 11 der Ausschaltstrom - I_{GS} nach dem Umschalten der Freilaufdiode 16 stark erhöht werden, um den Transistor 11 schneller vollständig zu sperren. Diese Stromerhöhung nach dem Umschaltvorgang der Freilaufdiode 16 kann bei Einschalten und beim Ausschalten des Transistors 11 auch analog kontinuierlich anstelle der beschriebenen schrittweisen Erhöhung erfolgen.

Bei den Ausführungsbeispielen wird der Ein- und Ausschaltstrom I_{GS} von einem anfänglich erhöhten Wert aus in Abhängigkeit der an der Freilaufdiode 16 abfallenden Spannung kontinuierlich verringert, insbesondere proportional verringert. Diese Stromverringerung kann anstelle in Abhängigkeit der Spannung U_{KA} an der Freilaufdiode 16 auch in Abhängigkeit von Parametern erfolgen, die von dieser Spannung U_{KA} abhängig sind oder die sich entsprechend dieser Spannung verändern.

## Patentansprüche

1. Gleichstrom-Steuerschaltung zum Ausschalten des Stromflusses in einem induktivitätsbehafteten Laststromkreis durch Ansteuern eines als MOSFET oder IGBT-Halbleiterschalter ausgebildeten Halbleiterschalters, wobei der Halbleiterschalter zur Steuerung wenigstens eines Verbrauchers des Laststromkreises mit diesem in Wirkverbindung steht und ein Freilauf-Halbleiterbauteil parallel zum Verbraucher geschaltet ist, und wobei ein zum Ausschalten ausgelöster Ausschaltsteuerstrom von einem höheren Ausgangswert aus so verkleinert wird, daß der Halbleiterschalter erst dann vollständig sperrt, wenn das Freilauf-Halbleiterbauteil in den stromleitenden Zustand umgeschaltet wird, **dadurch gekennzeichnet, daß** eine in Abhängigkeit von der Spannung am Freilauf-Halbleiterbauteil (16) steuerbare Ausschaltstromquelle (19) zur kontinuierlichen Verringerung des Betrags des Ausschaltsteuerstroms (- I_{GS}) bis zu einem Minimalwert (- I_{GSmin}) vorgesehen ist, wobei der Minimalwert im wesentlichen bei einem Spannungswert von 0 Volt der sich verringernden Spannung am Freilauf-Halbleiterbauteil (16) erreicht wird.

2. Steuerschaltung nach Anspruch 1, **dadurch gekennzeichnet, daß** die Ausschaltstromquelle (19) eine den sich bei gegen Null gehender Spannung am Freilauf-Halbleiterbauteil verringernden Ausschaltsteuerstrom auf dem Minimalwert haltende Begrenzungseinrichtung aufweist.

3. Steuerschaltung nach Anspruch 1 oder 2, **dadurch gekennzeichnet, daß** die Ausschaltstromquelle (19) Mittel zur Verringerung des Ausschaltsteuerstroms im wesentlichen proportional zur Veränderung der gegen Null gehenden Spannung am Freilauf--Halbleiterbauteil (16) aufweist.

4. Gleichstrom-Steuerschaltung zum Einschalten des Stromflusses in einem induktivitätsbehafteten Laststromkreis durch Ansteuern eines als MOSFET oder IGBT-Halbleiterschalter ausgebildeten Halbleiterschalters, wobei der Halbleiterschalter zur Steuerung wenigstens eines Verbrauchers des Laststromkreises mit diesem in Wirkverbindung steht, und ein Freilauf-Halbleiterbauteil parallel zum Verbraucher geschaltet ist und wobei ein zum Einschalten ausgelöster Einschaltsteuerstrom so eingestellt wird, daß der Halbleiterschalter erst dann vollständig leitet, wenn das Freilauf-Halbleiterbauteil in den stromsperrenden Zustand umgeschaltet hat, **dadurch gekennzeichnet, daß** eine in Abhängigkeit von der Spannung am Freilauf-Halbleiterbauteil (16) steuerbare Einschaltstromquelle (18) zur kontinuierlichen Verringerung des Betrages des Einschaltsteuerstroms (I_{Gs}) bis zu einem Minimalwert (I_{GSmin}) vorgesehen ist, wobei der Minimalwert im wesentlichen bei einem Spannungswert von 0 Volt der sich verringernden Spannung am Freilauf-Halbleiterbauteil (16) unmittelbar vor Unterschreiten seiner Schwellspannung erreicht wird.

5. Steuerschaltung nach Anspruch 4, **dadurch gekennzeichnet, daß** die Einschaltstromquelle (18) eine den sich verringernden Einschaltsteuerstrom auf den Minimalwert begrenzende Begrenzungseinrichtung aufweist.

6. Steuerschaltung nach Anspruch 4 oder 5, **dadurch gekennzeichnet, daß** die Einschaltstromquelle (18) Mittel (21) zur Verringerung des Einschaltsteuerstroms im wesentlichen proportional zur Veränderung der gegen Null gehenden Spannung am Freilauf-Halbleiterbauteil (16) aufweist.

7. Steuerschaltung nach einem der vorhergehenden Ansprüche, **dadurch gekennzeichnet, daß** der Minimalwert des Stromes der Ausschaltstromquelle (19) und/oder der Einschaltstromquelle (18) eine die notwendige Umschaltzeit für das Freilauf-Halbleiterbauteil (16) vorgebende geringe Größe (- I_{GS-min} bzw. I_{GSmin}) aufweist.

8. Steuerschaltung nach einem der vorhergehenden Ansprüche, **dadurch gekennzeichnet, daß** Mittel (22, 25, 26) zur Umschaltung der Ein- und/oder Ausschaltstromquelle (18) auf einen wesentlich höheren Betrag des Steuerstroms nach erfolgter Umschaltung des Freilauf-Halbleiterbauteils (16) vorgesehen sind.

9. Steuerschaltung nach Anspruch 8, **dadurch gekennzeichnet, daß** die Einschaltstromquelle (18) wen igstens zwei Teilstromquellen (21, 22) aufweist, die alternativ durch positive und negative Spannungen am Freilauf-Halbleiterbauteil (16) einschaltbar sind, wobei vorzugsweise zur alternativen Einschaltung invers gepolte Dioden (23, 26) entsprechend den Steuereingängen der Teilstromquellen (21, 22) vorgeschaltet sind.

10. Steuerschaltung nach einem der vorhergehenden Ansprüche , **dadurch gekennzeichnet, daß** Mittel (28 - 31) vorgesehen sind, die bei einer Unterschreitung der ausgangsseitigen Verbraucherspannung (U_{A}) unter einen vorgebbaren Bruchteil der Versorgungsspannung (U_{B}) einen den Halbleiterschalter (11) nicht mehr vollständig einschaltenden Einschaltsteuerstrom vorgeben.

11. Steuerschaltung nach Anspruch 10, **dadurch gekennzeichnet, daß** eine Vergleichsschaltung (29) zum Vergleich der Versorgungsspannung (U_{B}) mit der an wenigstens einem der Verbraucher abfallenden Spannung (U_{A}) vorgesehen ist, wobei durch diese Vergleichseinrichtung (29) der Betrag des Steuerstroms (I_{GS}) nach erfolgter Umschaltung des Freilauf-Halbleiterbauteils (16) in Abhängigkeit des Verhältnisses dieser Spannungen zueinander eingestellt wird.

12. Steuerschaltung nach einem der vorhergehenden Ansprüche, **dadurch gekennzeichnet, daß** dem Steuereingang des Halbleiterschalters (1) ein durch ein insbesondere als pulsweitenmoduliertes Signal ausgebildetes Steuersignal (PW) für seinen jeweiligen Schaltvorgang steuerbarer Umschalter (17) vorgeschaltet ist zur Umschaltung zwischen der Ein- und Ausschaltstromquelle (21, 19).

13. Steuerschaltung nach einem der Ansprüche 1 bis 11, **dadurch gekennzeichnet, daß** die Ein- und Ausschaltstromquelle (21, 19) durch ein insbesondere als pulsweitenmoduliertes Signal ausgebildetes Steuersignal (PW) betätigbare Eingänge zu ihrer alternativen Ein- und Ausschaltung aufweisen.

## Claims

1. Direct-current control circuit for interrupting the current flow in a load circuit subject to inductance by activating a semiconductor switch formed as a MOSFET or IGBT semiconductor switch, said semiconductor switch being actively connected to the load circuit for the purpose of controlling at least one of its loads and a freewheeling semiconductor component being connected in parallel with the load and the initial value of a turn-off current triggered for disconnection being so reduced that the semiconductor switch does not deactivate completely until the freewheeling semiconductor component is switched into the conductive state, **characterized in that** a turn-off current source (19) controllable in dependence on the voltage at the freewheeling semiconductor component (16) is provided for the continuous reduction of the magnitude of the turn-off current (- l_{GS}) to a minimum value (-I_{GSmin}), said minimum value being essentially reached at a value of 0 Volt of the decreasing voltage at the freewheeling semiconductor component (16).

2. Control circuit according to Claim 1. **characterized in that** the turn-off current source (19) is provided with a limiting device holding the turn-off current, which decreases while the voltage at the freewheeling semiconductor component approaches zero, at its minimum value.

3. Control circuit according to Claim 1 or 2. **characterized in that** the turn-off current source (19) is provided with means for reducing the turn-off current substantially in proportion to the change of the voltage at the freewheeling semiconductor component (16) approaching zero.

4. Direct-current control circuit for switching on the current flow in a load circuit subject to inductance by activating a semiconductor switch formed as a MOSFET or IGBT semiconductor switch, said semiconductor switch being actively connected to the load circuit for the purpose of controlling at least one of its loads and a freewheeling semiconductor component being connected in parallel with the load and a turn-on current triggered for switching on being so adjusted that the semiconductor switch does not conduct completely until the freewheeling semiconductor component has switched into the nonconducting state, **characterized in that** a turn-on current source (18) controllable in dependence on the voltage at the freewheeling semiconductor component (16) is provided for the continuous reduction of the magnitude of the turn-on current (l_{GS}) to a minimum value (I_{GSmin}), said minimum value being essentially reached at a value of 0 Volt of the decreasing voltage at the freewheeling semiconductor component (16) immediately before falling below its threshold voltage.

5. Control circuit according to Claim 4, **characterized in that** the turn-on current source (18) is provided with a limiting device holding the decreasing turn-on current at its minimum value.

6. Control circuit according to Claim 4 or 5, **characterized in that** the turn-on current source (18) is provided with means for reducing the turn-on current substantially in proportion to the change of the voltage at the freewheeling semiconductor component (16) approaching zero.

7. Control circuit according to any of the preceding claims, **characterized in that** the minimum value of the current of the turn-off current source (19) and/or the turn-on current source (18) has a low magnitude (- I_{GSmin} or I_{GSmin}) respectively) predetermining the required changeover time for the freewheeling semiconductor component.

8. Control circuit according to any of the preceding claims, **characterized in that** means (22, 25, 26) are provided for switching the turn-on and/or turn-off current source (18) to a substantially higher control current magnitude following the changeover of the freewheeling semiconductor component (16).

9. Control circuit according to Claim 8, **characterized in that** the turn-on current source (18) has at least two partial current sources (21, 22) capable of alternative activation by positive and negative voltages at the freewheeling semiconductor component (16), inversely polarized diodes (23, 26) corresponding to the control inputs of the partial current sources (21, 22) preferably being connected in series for alternative activation.

10. Control circuit according to any of the preceding claims, **characterized in that** means (28 - 31) are provided for presetting a turn-on current which does no longer completely activate the semiconductor switch (11) if the output load voltage (U_{A}) falls below a presettable fraction of the supply voltage (U_{B}).

11. Control circuit according to Claim 10, **characterized in that** a comparator circuit (29) is provided to compare the supply voltage (U_{B}) with the voltage (U_{A}) at one or more of the loads, said comparator circuit (29) adjusting the magnitude of the control current (I_{GS}) following the changeover of the freewheeling semiconductor component (16) in dependence on the ratio of these voltages.

12. Control circuit according to any of the preceding claims, **characterized in that** a changeover switch (17) controllable by a control signal (PW), in particular a pulse-width modulated signal, for each of its switching actions is connected in series with the control input of the semiconductor switch (1) for switching between the turn-on and turn-off current sources (21, 19).

13. Control circuit according to any of Claims 1 to 11, **characterized in that** the turn-on and turn-off current sources (21, 19) have inputs capable of operation by a control signal, in particular a pulse-width modulated signal, for their alternative activation and deactivation.

## Revendications

1. Circuit de commande à courant continu servant à déconnecter la conduction de courant dans un circuit de charge inductif, par amorçage d'un interrupteur à semi-conducteur conformé, en circuit MOSFET ou IGBT, l'interrupteur à semi-conducteur étant couplé en série avec au moins un consommateur du circuit de charge, pour la commande de celui-ci, et un composant semi-conducteur de roue libre étant couplé en parallèle au consommateur, et un courant de commande de mise hors circuit, déclenché pour déconnecter la conduction de courant, étant réduit, à partir d'une valeur initiale élevée, de manière à ce que l'interrupteur à semi-conducteur n'assure un blocage complet que lorsque le composant à semi-conducteur de roue libre a commuté pour passer dans l'état conducteur de courant, **caractérisé en ce qu'**est prévue une source de courant de mise hors circuit (19), modulable en fonction de la tension appliquée au composant semi-conducteur de roue libre (16), qui permet de réduire en continu la valeur du courant de commande (- I_{GS}) jusqu'à une valeur minimale (- l_{GSmin}), la valeur minimale étant sensiblement atteinte lorsque la tension qui diminue au niveau du composant semi-conducteur de roue libre (16) a atteint une valeur de 0 volt.

2. Circuit de commande selon la revendication 1, **caractérisé en ce que** la source de courant de mise hors circuit (19) présente un dispositif limiteur maintenant à la valeur minimale le courant de commande de mise hors circuit qui diminue lorsque la tension au niveau du composant semi-conducteur de roue libre se rapproche de la valeur zéro.

3. Circuit de commande selon la revendication 1 ou 2, **caractérisé en ce que** la source de courant de mise hors circuit (19) présente des moyens permettant de réduire le courant de commande de mise hors circuit de façon sensiblement proportionnelle à la variation de la tension se rapprochant de zéro, au niveau du composant semi-conducteur de roue libre (16).

4. Circuit de commande à courant continu servant à connecter la conduction de courant dans un circuit de charge inductif, par amorçage d'un interrupteur à semi-conducteur conformé, en circuit MOSFET ou IGBT, l'interrupteur à semi-conducteur étant couplé en série avec au moins un consommateur du circuit de charge, pour la commande de celui-ci, et un composant semi-conducteur de roue libre étant couplé en parallèle au consommateur, et un courant de commande de mise en circuit, déclenché pour connecter la conduction de courant, étant réglé de manière à ce que l'interrupteur à semi-conducteur n'assure une conduction complète que lorsque le composant à semi-conducteur de roue libre a commuté pour passer dans un état bloquant le courant, **caractérisé en ce qu'**est prévue une source de courant de mise en circuit (18), modulable en fonction de la tension appliquée au composant semi-conducteur de roue libre (16), qui permet de réduire en continu la valeur du courant de commande de mise en circuit (I_{GS}) jusqu'à une valeur minimale (l_{GSmin}), la valeur minimale étant sensiblement atteinte lorsque la tension qui diminue. au niveau du composant semi-conducteur de roue libre (16) a atteint une valeur de 0 volt, immédiatement avant de passer en-dessous de sa valeur de tension de seuil.

5. Circuit de commande selon la revendication 4, **caractérisé en ce que** la source de courant de mise en circuit (18) présente un dispositif limiteur maintenant à sa valeur minimale le courant de commande de mise en circuit qui diminue.

6. Circuit de commande selon la revendication 4 ou 5, **caractérisé en ce que** la source de courant de mise en circuit (18) présente des moyens (21) permettant de réduire le courant de commande de mise en circuit de façon sensiblement proportionnelle à la variation de la tension se rapprochant de zéro, au niveau du composant semi-conducteur de roue libre (16).

7. Circuit de commande selon l'une des revendications précédentes, **caractérisé en ce que** la valeur minimale du courant de la source de courant de mise hors circuit (19) et/ou de la source de courant de mise en circuit (18) présente une valeur faible (- I_{GSmin} et/ou I_{GSmin}) indiquant le temps de commutation nécessaire pour le composant semi-conducteur de roue libre (16).

8. Circuit de commande selon l'une des revendications précédentes, **caractérisé en ce que** sont prévus des moyens (22, 25, 26) de commutation de la et/ou des source(s) de courant de mise en/hors circuit (18) pour atteindre une valeur du courant de commande nettement supérieure une fois que le composant semi-conducteur de roue libre (16) a commuté.

9. Circuit de commande selon la revendication 8, **caractérisé en ce que** la source de courant de mise en circuit (18) présente au moins deux sources de courant partiel (21, 22), qui sont susceptibles d'être connectées, en alternance, sur des tensions positives et négatives au niveau du composant semi-conducteur de roue libre (16), des diodes (23, 26) inversement polarisées, correspondant aux entrées de commande des sources de courant partiel (21, 22), étant de préférence montées en amont, pour assurer la connexion en alternance.

10. Circuit de commande selon l'une des revendications précédentes, **caractérisé en ce que** sont prévus des moyens (28-31) qui, lorsque la tension du consommateur (U_{A}), située du côté de la sortie, passe en-dessous d'une fraction, susceptible d'être prescrite, de la tension d'alimentation (U_{B}), prescrivent un courant de commande de mise en circuit qui ne met plus complètement en circuit l'interrupteur à semi-conducteur (11).

11. Circuit de commande selon la revendication 10, **caractérisé en ce qu'**est prévu un circuit comparateur (29) destiné à comparer la tension d'alimentation (U_{B}) avec la tension (U_{A}) chutant au niveau d'au moins un des consommateurs, la valeur du courant de commande (l_{GS}), après la commutation du composant semi-conducteur de roue libre (16), étant réglée grâce à ce dispositif comparateur (29) en fonction du rapport de ces tensions entre elles.

12. Circuit de commande selon l'une des revendications précédentes, **caractérisé en ce qu'**un commutateur (17), susceptible d'être commandé, pour sa fonction respective de commutation, par un signal de commande (PW) conformé, en particulier, en signal à modulation d'impulsions en largeur, est monté en amont de l'entrée de commande de l'interrupteur à semi-conducteur (11), afin d'assurer la commutation entre les sources de courant de mise en et hors circuit (21, 19).

13. Circuit de commande selon l'une des revendications 1 à 11, **caractérisé en ce que** les sources de courant de mise en et hors circuit (21, 19) présentent des entrées actionnables au moyen d'un signal de commande (PW) conformé, en particulier, en signal à modulation d'impulsions en largeur, afin d'assurer, en alternance, leur mise en et hors circuit.
